# EUROPEAN PATENT APPLICATION

(11) **EP 3 125 248 A1**
(43) Date of publication of application: **01.02.2017**
(21) Application number: 14890156.4
(22) Date of filing: 22.04.2014
(51) Int. Cl.: G11C 11/00

(54) **LATCH AND D TRIGGER**

(71) Applicant: Huawei Technologies Co., Ltd., Shenzhen, Guangdong 518129 (CN)
(72) Inventor: MIAO, Xiangshui, Wuhan Hubei 430074 (CN); LI, Yi, Wuhan Hubei 430074 (CN); ZHOU, Yaxiong, Wuhan Hubei 430074 (CN); XU, Ronggang, Shenzhen Guangdong 518129 (CN); ZHAO, Junfeng, Shenzhen Guangdong 518129 (CN); ZHANG, Shujie, Shenzhen Guangdong 518129 (CN)
(74) Representative: Körber, Martin Hans
(86) International application number: PCT/CN2014/075966
(87) International publication number: WO 2015/161450

(57) **Abstract**

Embodiments of the present invention provide a latch and a D flip-flop. The latch includes: a switch, a resistive random-access memory, a bleeder circuit, and a voltage converter. When the switch is in an on state, the voltage converter is configured to output an output signal of the latch according to an input signal of the latch, where the output signal remains consistent with the input signal. When the switch changes from the on state to an off state, the resistive random-access memory is configured to work together with the bleeder circuit to enable an output signal of the latch when the switch is in the off state to remain consistent with an output signal of the latch when the switch is in the on state, thereby implementing a nonvolatile latching function. Because fewer components are used in the latch in the embodiments of the present invention, a circuit structure is simple, a circuit area is reduced, and integrity of an existing logic circuit can be improved.

## Description

### TECHNICAL FIELD

Embodiments of the present invention relate to digital circuit technologies, and in particular, to a latch and a D flip-flop.

### BACKGROUND

A latch (Latch) is a storage unit circuit sensitive to a pulse level, and can change a status under an action of a specific input pulse level. Latching refers to temporarily storing a signal to maintain a level status. A most important function of a latch is buffering. A typical latch logic circuit is a D flip-flop circuit. A D flip-flop is generally of a master-slave structure. A function of a flip-flop is implemented by cascading two latches (Latch) and then applying opposite clock signals to the two latches.

Existing latches are mostly implemented by using a complementary metal-oxide-semiconductor (Complementary Metal Oxide Semiconductor, CMOS for short) technology. However, a latch implemented by using a CMOS circuit is complex in structure. Moreover, a circuit implemented by using the CMOS technology is volatile; therefore, after the circuit is powered off, a working status, before power-off, of the circuit cannot be stored. As latches and D flip-flops are applied more widely, it is urgent that after a device is powered off, a latch can still maintain a working status, before power-off, of the device. Therefore, demands for nonvolatile latches and D flip-flops increase gradually.

### SUMMARY

Embodiments of the present invention provide a latch and a D flip-flop, so that in a case of power-off, a working status, before the power-off, of a circuit can still be maintained.

A first aspect of the present invention provides a latch, including a switch, a resistive random-access memory, a bleeder circuit, and a voltage converter, where:
a first end of the switch is configured to input a control signal, and the control signal is used to control the switch to be in an on state or an off state;
a second end of the switch is an input end of the latch;
a third end of the switch is connected to a positive electrode of the resistive random-access memory, a first end of the bleeder circuit, and an input end of the voltage converter;
a negative electrode of the resistive random-access memory is connected to a control power supply;
a second end of the bleeder circuit is grounded;
an output end of the voltage converter is an output end of the latch;
when the switch is in the on state, the voltage converter is configured to output an output signal of the latch according to an input signal of the latch, where the output signal of the latch remains consistent with the input signal of the latch; and
when the switch changes from the on state to the off state, the resistive random-access memory is configured to work together with the bleeder circuit to enable an output signal of the latch when the switch is in the off state to remain consistent with an output signal of the latch when the switch is in the on state.

With reference to the first aspect of the present invention, in a first possible implementation manner of the first aspect of the present invention, when the switch is in the on state, the resistive random-access memory is further configured to present a resistive state according to a difference between a voltage of the control power supply and a voltage of the input signal of the latch; and
when the switch changes from the on state to the off state, the resistive random-access memory is further configured to maintain the resistive state, to enable a voltage of the bleeder circuit to meet a preset condition, so that the output signal of the latch when the switch is in the off state remains consistent with the output signal of the latch when the switch is in the on state.

With reference to the first possible implementation manner of the first aspect of the present invention, in a second possible implementation manner of the first aspect of the present invention, when the resistive random-access memory maintains the resistive state, the voltage of the bleeder circuit is (R/(Rₘ+R))*Vₘ, where R is a resistance value of the bleeder circuit, Rₘ is a resistance value of the resistive random-access memory in the first resistive state, Vₘ is the voltage of the control power supply, and the first resistive state is a high resistive state or a low resistive state.

With reference to the second possible implementation manner of the first aspect of the present invention, in a third possible implementation manner of the first aspect of the present invention, the voltage converter is configured to: convert the voltage of the bleeder circuit to a high level if the voltage of the bleeder circuit is greater than or equal to a voltage conversion threshold; or convert the voltage of the bleeder circuit to a low level if the voltage of the bleeder circuit is less than the voltage conversion threshold; and
the voltage conversion threshold meets the following condition: (R/(R+Rₘₕ))Vₘ≤Vₜₕ≤(R/(R+Rₘₗ))Vₘ, where Vₜₕ is the voltage conversion threshold, Rₘₗ is a resistance value of the resistive random-access memory in the low resistive state, and Rₘₕ is a resistance value of the resistive random-access memory in the high resistive state.

With reference to the first aspect of the present invention and the first to third possible implementation manners of the first aspect, in a fourth possible implementation manner of the first aspect of the present invention, the switch includes a field-effect transistor, a gate of the field-effect transistor is configured to input the control signal, a drain of the field-effect transistor is the input end of the latch, and a source of the field-effect transistor is connected to the positive electrode of the resistive random-access memory, the first end of the bleeder circuit, and the input end of the voltage converter.

With reference to the fourth possible implementation manner of the first aspect of the present invention, in a fifth possible implementation manner of the first aspect of the present invention, the field-effect transistor is a P-type field-effect transistor or an N-type field-effect transistor.

With reference to the first aspect of the present invention and the first to fifth possible implementation manners of the first aspect, in a sixth possible implementation manner of the first aspect of the present invention, the bleeder circuit is a bleeder resistor.

A second aspect of the present invention provides a D flip-flop, including at least two latches according to any one of claims 1 to 7, where the at least two latches include a first latch and a second latch, where:
an output end of the first latch is an input end of the second latch;
a first end of a switch of the first latch and a first end of a switch of the second latch are configured to input a control signal, where the switch of the first latch and the switch of the second latch are not in an on state at the same time under the control of the control signal;
a second end of the switch of the first latch is an input end of the D flip-flop; and
an output end of a voltage converter of the second latch is an output end of the D flip-flop.

With reference to the second aspect of the present invention, in a first possible implementation manner of the second aspect of the present invention, when the switch of the first latch is a P-type field-effect transistor, the switch of the second latch is an N-type field-effect transistor; or
when the switch of the first latch is an N-type field-effect transistor, the switch of the second latch is a P-type field-effect transistor.

The embodiments provide a latch and a D flip-flop. The latch includes a switch, a resistive random-access memory, a bleeder circuit, and a voltage converter. When the switch is on, the voltage converter may output an output signal of the latch according to an input signal of the latch, where the output signal remains consistent with the input signal. When the switch changes from an on state to an off state, the resistive random-access memory works together with the bleeder circuit to enable an output signal of the latch when the switch is in the off state to remain consistent with an output signal of the latch when the switch is in the on state. Therefore, in a case of power-off, a working status, before the power-off, of a circuit can still be maintained, thereby implementing a nonvolatile latching function. In addition, according to the latch provided in the embodiments of the present invention, non-volatility is achieved; and because fewer components are used in the latch, a circuit structure is simple, a circuit area is reduced, the latch is compatible with an existing CMOS technology, and integrity of an existing logic circuit can be improved.

### BRIEF DESCRIPTION OF DRAWINGS

To describe the technical solutions in the embodiments of the present invention or in the prior art more clearly, the following briefly introduces the accompanying drawings required for describing the embodiments or the prior art.
FIG. 1 is a schematic diagram of a volt-ampere characteristic curve of a resistive random-access memory;
FIG. 2 is a schematic diagram of a circuit structure of a latch according to an embodiment of the present invention;
FIG. 3 is a sequence diagram of the latch shown in FIG. 2;
FIG. 4 is a schematic diagram of a circuit structure of another latch according to an embodiment of the present invention;
FIG. 5 is a schematic diagram of a circuit structure of still another latch according to an embodiment of the present invention;
FIG. 6 is a schematic diagram of a circuit structure of a D flip-flop according to an embodiment of the present invention;
FIG. 7 is a sequence diagram of the D flip-flop shown in FIG. 6;
FIG. 8 is a schematic diagram of a circuit structure of another D flip-flop according to an embodiment of the present invention; and
FIG. 9 is a schematic diagram of a circuit structure of still another D flip-flop according to an embodiment of the present invention.

### DESCRIPTION OF EMBODIMENTS

To make the objectives, technical solutions, and advantages of the embodiments of the present invention clearer, the following clearly and completely describes the technical solutions of the embodiments of the present invention with reference to the accompanying drawings in the embodiments of the present invention. Apparently, the described embodiments are some but not all of the embodiments of the present invention.

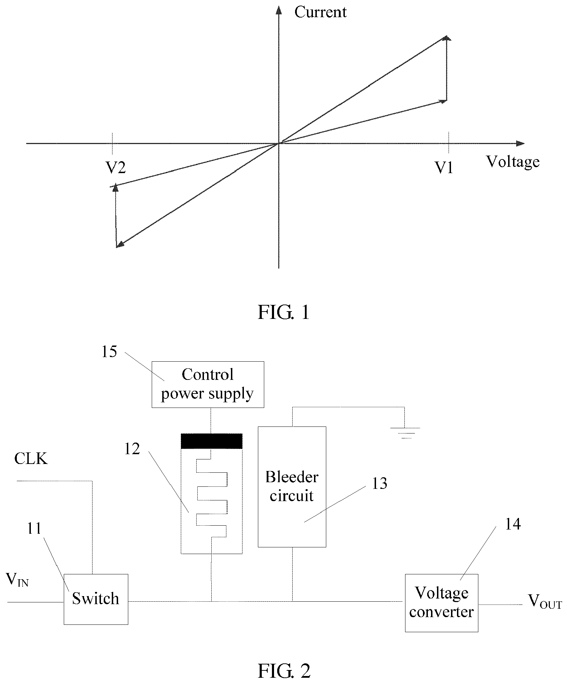

Before the technical solutions in the embodiments of the present invention are introduced, a resistive random-access memory is introduced first. A resistive random-access memory (Resistive random-access memory, RRAM for short) is a memory, where resistance of a material of the resistive random-access memory changes accordingly between a high resistive state and a low resistive state according to different voltages applied to the resistive random-access memory, so as to open or close a current flow channel, and various information is stored by using this property. FIG. 1 is a schematic diagram of a volt-ampere characteristic curve of a resistive random-access memory. It can be seen from FIG. 1 that when a forward voltage applied to two ends of the resistive random-access memory is greater than or equal to a first resistance changing threshold V₁, the resistive random-access memory changes from a high resistive state to a low resistive state; and when a negative voltage applied to the two ends of the resistive random-access memory is less than or equal to a second resistance changing threshold V₂, the resistive random-access memory changes from the low resistive state to the high resistive state. A value of the first resistance changing threshold V₁ is greater than 0 V and is less than or equal to a voltage Vₘ provided by a control power supply, a value of the second resistance changing threshold V₂ is greater than or equal to -Vₘ and is less than 0 V, and -Vₘ and Vₘ are equal in absolute voltage value but are opposite in voltage polarity.

Based on the foregoing characteristic of the resistive random-access memory, in the embodiments of the present invention, a voltage at two ends of a resistive random-access memory is controlled to achieve an objective of controlling a resistive state of the resistive random-access memory, and logic "0" and "1" are stored by changing the resistive state of the resistive random-access memory. For example, when the resistive random-access memory is in the low resistive state, a latch stores logic 1, and when the resistive random-access memory is in the high resistive state, the latch stores logic 0. Certainly, when the resistive random-access memory is in the low resistive state, a latch may store logic 0, and when the resistive random-access memory is in the high resistive state, the latch may store logic 1.

FIG. 2 is a schematic diagram of a circuit structure of a latch according to an embodiment of the present invention. As shown in FIG. 2, the latch in this embodiment includes: a switch 11, a resistive random-access memory 12, a bleeder circuit 13, and a voltage converter 14.

A first end of the switch 11 is configured to input a control signal. A second end of the switch 11 is an input end of the latch and is configured to input an input signal (V_{IN}). A third end of the switch 11 is connected to a positive electrode of the resistive random-access memory 12, a first end of the bleeder circuit 13, and an input end of the voltage converter 14. A negative electrode of the resistive random-access memory 12 is connected to a control power supply 15. A second end of the bleeder circuit 13 is grounded. An output end of the voltage converter 14 is an output end of the latch.

When the switch 11 is in an on state, the voltage converter 14 is configured to output an output signal of the latch according to an input signal of the latch, where the output signal of the latch remains consistent with the input signal of the latch.

When the switch 11 changes from the on state to an off state, the resistive random-access memory 12 is configured to work together with the bleeder circuit 13 to enable an output signal of the latch when the switch 11 is in the off state to remain consistent with an output signal of the latch when the switch 11 is in the on state.

In this embodiment, on and off of the switch 11 are mainly controlled by using a value of a voltage, and the switch 11 may be any existing switch. For example, the switch 11 may be a voltage-controlled switch such as a field-effect transistor. An implementation form of the switch 11 is not limited in this embodiment. In this embodiment of the present invention, when the switch 11 is a field-effect transistor, a gate of the field-effect transistor may be configured to input the control signal, and a drain of the field-effect transistor may be the input end of the latch. A source of the field-effect transistor is connected to the positive electrode of the resistive random-access memory M, the first end of the bleeder circuit, and the input end of the voltage converter. The field-effect transistor may be specifically a P-type field-effect transistor or an N-type field-effect transistor.

In a case, when the switch 11 is in the on state, the resistive random-access memory 12 is specifically configured to present a resistive state according to a difference between a voltage of the control power supply 15 and a voltage of the input signal. If the switch 11 is in the on state, a voltage at the input end of the voltage converter 14 is the input signal of the latch, and the voltage converter 14 may output the output signal of the latch according to the input signal, so that the output signal of the latch remains consistent with the input signal of the latch.

In another case, when the switch 11 changes from the on state to the off state, the resistive random-access memory 12 is further configured to maintain a resistive state of the resistive random-access memory 12 when the switch is in the on state, to enable a voltage of the bleeder circuit 13 to meet a preset condition, so that the output signal of the latch remains consistent with the output signal when the switch 11 is in the on state.

Specifically, in this embodiment of the present invention, when the switch 11 changes from the on state to the off state, the resistive random-access memory 12 maintains the resistive state. When the resistive random-access memory maintains the resistive state, the voltage of the bleeder circuit 13 is (R/(Rₘ+R))*Vₘ, where R is a resistance value of the bleeder circuit 13, Rₘ is a resistance value of the resistive random-access memory 12 in the first resistive state, Vₘ is the voltage of the control power supply 15, and the first resistive state may be a high resistive state or a low resistive state. The voltage converter 14 may convert the voltage of the bleeder circuit 13 to a high level if the voltage of the bleeder circuit 13 is greater than or equal to a voltage conversion threshold. The voltage converter 14 may convert the voltage of the bleeder circuit 13 to a low level if the voltage of the bleeder circuit 13 is less than a voltage conversion threshold. In this embodiment of the present invention, the voltage conversion threshold needs to meet the following condition: (R/(R+Rₘₕ))Vₘ≤Vₜₕ≤(R/(R+Rₘₗ))Vₘ, where Vₜₕ is the voltage conversion threshold, Rₘₗ is a resistance value of the resistive random-access memory 12 in the low resistive state, and Rₘₕ is a resistance value of the resistive random-access memory 12 in the high resistive state.

In this embodiment of the present invention, the first end of the bleeder circuit 13 is connected to the third end of the switch 11, and the second end of the bleeder circuit 13 is grounded. The bleeder circuit 13 may be a bleeder resistor. For example, the bleeder circuit 13 may be one bleeder resistor, or may be formed by multiple bleeder resistors connected in series. A specific implementation form of the bleeder circuit 13 is not limited in this embodiment.

In this embodiment, a specific implementation form of the voltage converter 14 is not limited either. The voltage converter 14 is configured to convert an input voltage to a standard high level or low level when the input voltage meets a preset condition. For example, if a high level of the voltage converter 14 is 5 V and a low level of the voltage converter 14 is 0 V, the voltage converter 14 may convert the input voltage to the high level 5 V or the low level 0 V.

It should be noted that, in this embodiment of the present invention, the voltage Vₘ provided by the control power supply 15 needs to meet the following condition: when a voltage applied to two ends of the resistive random-access memory 12 is -Vₘ, the resistive random-access memory 12 is enabled to present the high resistive state, and when the voltage applied to the two ends of the resistive random-access memory 12 is V_{DD}-Vₘ, the resistive random-access memory 12 is enabled to present the low resistive state. V_{DD} is a voltage of an input signal of the latch, and the input signal of the latch may be provided by a circuit power supply. Certainly, Vₘ may be provided by the circuit power supply, and when Vₘ is provided by the circuit power supply, the circuit power supply converts V_{DD} to Vₘ and then provides Vₘ to the resistive random-access memory 12.

The voltage Vₘ of the control power supply 15 needs to further meet the following condition: when the control signal changes from a high level to a low level, that is, the switch 11 changes from the on state to the off state, the voltage Vₘ does not enable the resistive state of the resistive random-access memory 12 to change. That is, when the switch 11 changes from the on state to the off state, the input voltage Vₘ does not enable the resistive random-access memory 12 to change from the high resistive state to the low resistive state, and does not enable the resistive random-access memory 12 to change from the low resistive state to the high resistive state either. In this manner, the resistive random-access memory 12 can maintain a resistive state that is presented by the resistive random-access memory 12 when the switch 11 is on. Specifically, if the resistive state presented by the resistive random-access memory 12 is the low resistive state when the switch 11 is in the on state, when the switch 11 changes from the on state to the off state, a voltage at the two ends of the resistive random-access memory 12 is V_{low}=(Rₘₗ/(R+Rₘₗ))Vₘ, where Rₘₗ is the resistance value of the resistive random-access memory 12 in the low resistive state, R is the resistance value of the bleeder circuit 13, and Vₘ is the voltage of the control power supply 15. A value of V_{low} should meet the following condition: the value of V_{low} does not enable the resistive random-access memory 12 to change from the low resistive state to the high resistive state. If the resistive state presented by the resistive random-access memory 12 is the high resistive state when the switch 11 is in the on state, when the switch 11 changes from the on state to the off state, a voltage on the resistive random-access memory 12 is V_{high}=(Rₘₕ/(R+Rₘₕ))Vₘ, where Rₘₕ is the resistance value of the resistive random-access memory 12 in the high resistive state, R is the resistance value of the bleeder circuit 13, and Vₘ is the voltage of the control power supply 15. A value of V_{high} needs to meet the following condition: the value of V_{high} does not enable the resistive random-access memory 12 to change from the high resistive state to the low resistive state in a latching process.

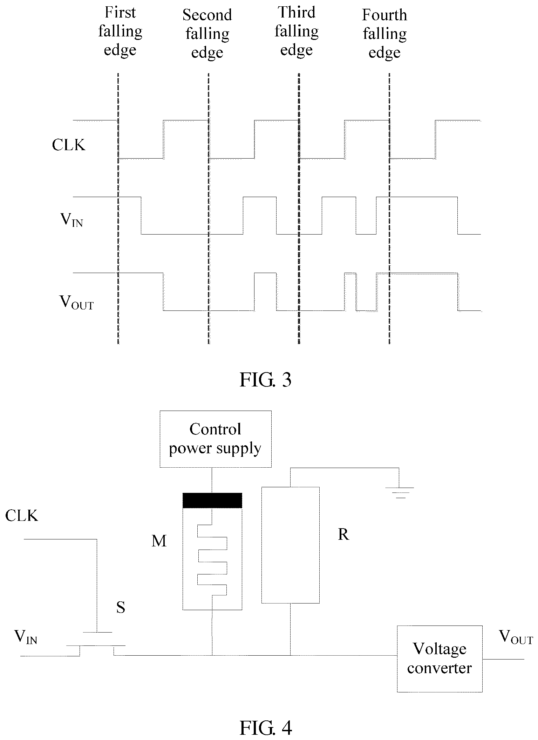

FIG. 3 is a sequence diagram of the latch shown in FIG. 2. The following specifically explains, with reference to FIG. 2 and FIG. 3, a working principle of the latch provided in this embodiment.

In this embodiment, an example in which a falling edge of the latch is valid is used for description. When the control signal is at a high level, where the control signal may be a clock signal CLK, that is, when CLK=1, the switch 11 is on; if the input signal of the latch is at a high level, that is, V_{IN}=1, and a voltage of the input signal is represented by, for example, V_{DD}, a voltage applied to the positive electrode of the resistive random-access memory 12 is V_{DD}; in this case, if a voltage of 0.5 V_{DD} is applied to the negative electrode of the resistive random-access memory 12 by using the control power supply 15, a forward bias applied to the two ends of the resistive random-access memory 12 is 0.5 V_{DD}.

For example, when CLK=1 and V_{IN}=1, and it is assumed that V_{DD}=5 V and the first threshold V₁ of the resistive random-access memory 12 satisfies V₁=1.5 V, the voltage at the two ends of the resistive random-access memory 12 is 2.5 V, the voltage applied to the two ends of the resistive random-access memory 12 is greater than or equal to the first resistance changing threshold V₁, and the resistive random-access memory 12 is set to the low resistive state. In this case, the voltage of the bleeder circuit 13 is equal to the voltage of the input signal V_{IN}, and the voltage of the bleeder circuit 13 is at a high level. If the voltage conversion threshold of the voltage converter 14 is, for example, 2 V, an input voltage of the voltage converter 14 is greater than the voltage conversion threshold, and the voltage converter 14 may convert the input voltage to a high level, that is, when a high level is input into the latch, the latch stores logic 1.

When the control signal changes from the high level to the low level, that is, when CLK=0 and V_{IN}=1, the voltage of the bleeder circuit 13 is (R/(Rₘ+R))*Vₘ, and in this case, the resistive random-access memory 12 maintains the low resistive state, Rₘ is very small, the voltage of the bleeder circuit 13 is approximately Vₘ, the voltage of the bleeder circuit 13 is greater than or equal to the voltage conversion threshold, the voltage converter 14 converts the voltage of the bleeder circuit 13 to a high level, and the output signal of the latch remains consistent with output when the switch 11 is in the on state. Therefore, when the switch 11 changes from the on state to the off state, the latch can maintain the output signal when the switch 11 is in the on state.

When CLK=1, V_{IN}=0, V_{DD}=5 V, and V₂=-1.5 V, that is, when the input signal of the latch is at a low level, a bias applied to the two ends of the resistive random-access memory 12 is -0.5 V_{DD}, the bias at the two ends of the resistive random-access memory 12 is less than or equal to the second resistance changing threshold V₂, and the resistive random-access memory 12 is set to the high resistive state. In this case, the voltage of the bleeder circuit 13 is equal to the voltage (0 V) of the input signal V_{IN}. In this manner, the input voltage of the voltage converter 14 is also 0 V, the input voltage of the voltage converter 14 is less than the voltage conversion threshold, and the voltage converter 14 converts the input voltage to a low level, that is, when V_{IN}=0, the latch outputs the low level. It can be learned from the foregoing description that, when a low level is input into the latch, the latch stores logic 0.

When the control signal changes from the high level to the low level, that is, when CLK=0 and V_{IN}=0, because the resistive random-access memory 12 still maintains the high resistive state, the voltage of the bleeder circuit 13 is (R/(Rₘ+R))*Vₘ, Rₘ is very large, and the voltage of the bleeder circuit 13 is approximately 0, the input voltage of the voltage converter 14 is less than the voltage conversion threshold, and the voltage converter 14 outputs a low level, so that the output signal of the latch remains consistent with output when the switch 11 is in the on state. In this manner, when the switch 11 changes from the on state to the off state, the latch can maintain the output signal when the switch 11 is in the on state.

It can be learned from the foregoing description that, when CLK=0, the latch can maintain an output value when the switch 11 is in the on state, that is, the latch presents a hold state. As shown in FIG. 3, at a first falling edge, CLK is at a high level, V_{IN}=1, and the latch outputs a high level; and after CLK changes to a low level, the latch maintains an output value when CLK is at the high level, that is, maintains the high level. Similarly, at a second falling edge, V_{IN}=0, and the latch outputs a low level; and after CLK changes to a low level, the latch maintains the low level. At a third falling edge, V_{IN}=0, and the latch outputs a low level; and after CLK changes to a low level, the latch maintains the low level. At a fourth falling edge, V_{IN}=1, and the latch outputs a high level; and after CLK changes to a low level, the latch maintains the high level.

The foregoing working principle of the latch is described by using an example in which the falling edge of the latch is valid. Certainly, a rising edge of the latch may be valid, and a working principle of the latch when the rising edge is valid is similar to that when the falling edge is valid, and is not repeatedly described herein. In addition, the example in which the input signal of the latch is V_{DD} and the voltage of the control power supply is 0.5 V_{DD} is used for description in this embodiment. It can be understood that, the input signal may not be V_{DD} and the voltage of the control power supply may not be 0.5 V_{DD} either, as long as the voltages of the input signal and the control power supply meet a requirement for changing of the resistive state of the resistive random-access memory.

The latch in this embodiment includes a switch, a resistive random-access memory, a bleeder circuit, and a voltage converter. When the switch is on, the voltage converter may output an output signal of the latch according to an input signal of the latch, where the output signal remains consistent with the input signal. When the switch changes from an on state to an off state, the resistive random-access memory is configured to work together with the bleeder circuit to enable an output signal of the latch when the switch is in the off state to remain consistent with an output signal of the latch when the switch is in the on state, thereby implementing a nonvolatile latching function. According to the latch provided in this embodiment, non-volatility is achieved, and because fewer components are used in the latch, a circuit structure is simple, a circuit area is reduced, and the latch can be well compatible with an existing CMOS technology.

FIG. 4 is a schematic diagram of a circuit structure of another latch according to an embodiment of the present invention. A difference between this embodiment and the embodiment shown in FIG. 2 lies in that: in this embodiment, a switch 11 is implemented by using a field-effect transistor, and a bleeder circuit 13 is implemented by using a resistor. As shown in FIG. 4, the latch provided in this embodiment includes: a field-effect transistor S, a resistive random-access memory M, a bleeder resistor R, and a voltage converter.

A gate of the field-effect transistor S is configured to input a control signal, a drain of the field-effect transistor S is an input end of the latch, and a source of the field-effect transistor S is connected to a positive electrode of the resistive random-access memory M, a first end of the bleeder resistor R, and an input end of the voltage converter. A negative electrode of the resistive random-access memory M is connected to a control power supply. A second end of the bleeder resistor R is grounded. An output end of the voltage converter is an output end of the latch.

For a working principle of the latch provided in this embodiment, reference may be made to the description of the embodiment shown in FIG. 2, and details are not described herein again. The latch in this embodiment includes one field-effect transistor, one resistive random-access memory, one resistor, and one voltage converter. Because only four components are used, compared with a latch in the prior art, the latch in this embodiment is simpler in structure, lower in cost, and smaller in circuit area, the latch is compatible with an existing CMOS technology, and integrity of an existing logic circuit can be improved.

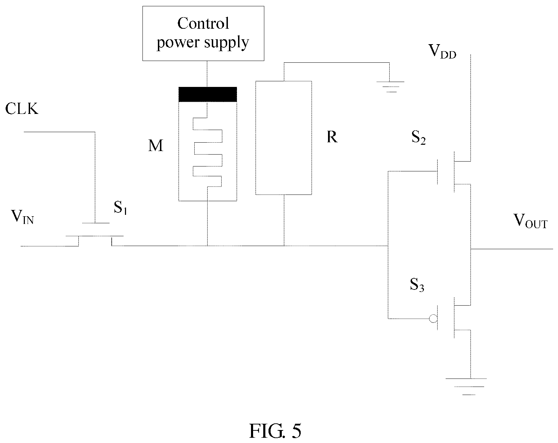

FIG. 5 is a schematic diagram of a circuit structure of still another latch according to an embodiment of the present invention. A difference between this embodiment and the embodiment shown in FIG. 4 lies in that: in this embodiment, a voltage converter is implemented by using two field-effect transistors. Referring to FIG. 5, the latch in this embodiment includes: a field-effect transistor S1, a resistive random-access memory M, a bleeder resistor R, a field-effect transistor S2, and a field-effect transistor S3. The field-effect transistor S2 and the field-effect transistor S3 together constitute the voltage converter. The field-effect transistor S2 and the field-effect transistor S3 are opposite in polarity. That is, when the field-effect transistor S2 is an N-type field-effect transistor, the field-effect transistor S3 is a P-type field-effect transistor; or when the field-effect transistor S2 is a P-type field-effect transistor, the field-effect transistor S3 is an N-type field-effect transistor.

A gate of the field-effect transistor S1 is configured to input a control signal, a drain of the field-effect transistor S1 is an input end of the latch, and a source of the field-effect transistor S1 is connected to a positive electrode of the resistive random-access memory M, a first end of the bleeder resistor R, a gate of the field-effect transistor S2, and a gate of the field-effect transistor S3. A negative electrode of the resistive random-access memory M is connected to a control power supply. A second end of the bleeder resistor R is grounded. The gate of the field-effect transistor S2 is connected to the source of the field-effect transistor S1, a source of the field-effect transistor S2 is connected to an external power supply, and a drain of the field-effect transistor S2 is an output end of the latch. The gate of the field-effect transistor S3 is connected to the source of the field-effect transistor S1, a source of the field-effect transistor S3 is grounded, and a drain of the field-effect transistor S3 is the output end of the latch.

In this embodiment, a working principle of the voltage converter is specifically: when CLK=1 and V_{IN}=1, the resistive random-access memory M presents a low resistive state, a voltage of the bleeder circuit is equal to a voltage of an input signal V_{IN}, and the voltage of the bleeder circuit enables the field-effect transistor S2 to be on, the field-effect transistor S3 to be off, and the latch to output a high level. When the control signal changes from a high level to a low level, that is, when CLK=0 and V_{IN}=1, the voltage of the bleeder circuit is (R/(Rₘ+R))*Vₘ. In this case, the resistive random-access memory M maintains the low resistive state, Rₘ is very small, the voltage of the bleeder circuit is approximately Vₘ, and the voltage of the bleeder circuit enables the field-effect transistor S2 to be on, the field-effect transistor S3 to be off, and the latch to still output a high level.

When CLK=1 and V_{IN}=0, the resistive random-access memory M presents a high resistive state. A voltage of the bleeder circuit is equal to an input voltage of the latch, that is, the voltage of the bleeder circuit is 0 V, and the voltage of the bleeder circuit enables the field-effect transistor S2 to be off, the field-effect transistor S3 to be on, and the latch to output a low level. When the control signal changes from a high level to a low level, that is, when CLK=0 and V_{IN}=0, because the resistive random-access memory M still maintains the high resistive state, Rₘ is very large, the voltage of the bleeder circuit is (R/(Rₘ+R))*Vₘ and is approximately 0, and the voltage of the bleeder circuit enables the field-effect transistor S2 to be off, the field-effect transistor S3 to be on, and the latch to still output a low level.

For a working principle of the latch provided in this embodiment, reference may be made to the description of the embodiment shown in FIG. 2, and details are not described herein again. The latch in this embodiment includes three field-effect transistors, one resistive random-access memory, and one resistor. Because only five components are used, compared with a latch in the prior art, the latch in this embodiment is simpler in structure and lower in cost.

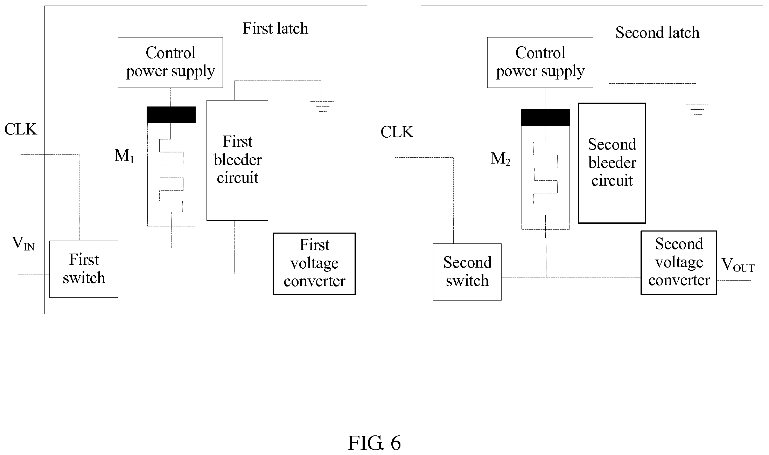

FIG. 6 is a schematic diagram of a circuit structure of a D flip-flop according to an embodiment of the present invention. The D flip-flop provided in this embodiment includes connecting two latches in series in a master-slave structure, and the latch is the latch shown in FIG. 2. As shown in FIG. 6, the D flip-flop provided in this embodiment includes: a first latch and a second latch. The first latch includes: a first switch, a resistive random-access memory M1, a first bleeder circuit, and a first voltage converter. The second latch includes: a second switch, a resistive random-access memory M2, a second bleeder circuit, and a second voltage converter.

In this embodiment of the present invention, an output end of the first latch is used as an input end of the second latch. A first end of the switch of the first latch and a first end of the switch of the second latch are configured to input a control signal. The switch of the first latch and the switch of the second latch are not in an on state at the same time under the control of the control signal, that is, when the switch of the first latch is on, the switch of the second latch is off, or when the switch of the first latch is off, the switch of the second latch is on.

A second end of the switch of the first latch is an input end of the D flip-flop. An output end of the voltage converter of the second latch is an output end of the D flip-flop, that is, the output end of the second voltage converter is the output end of the D flip-flop.

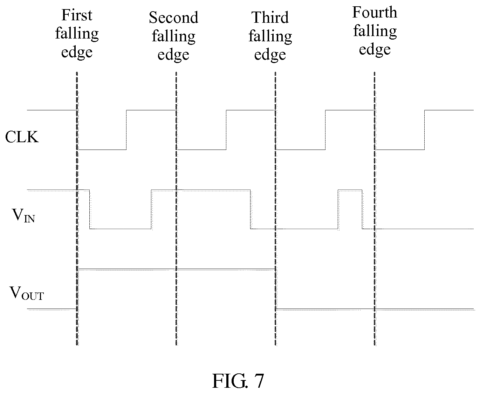

FIG. 7 is a sequence diagram of the D flip-flop shown in FIG. 6. The following specifically explains, with reference to FIG. 6 and FIG. 7, a working principle of the D flip-flop provided in this embodiment. In this embodiment, an example in which a falling edge of the D flip-flop is valid is used for description. For ease of description, in this embodiment of the present invention, the switch of the first latch is called the first switch, and the switch of the second latch is called the second switch.

When the control signal is at a high level, where the control signal may be a clock signal, that is, when CLK=1, the first switch is on; and if an input signal of the D flip-flop is at a high level, that is, V_{IN}=1, the resistive random-access memory M1 is set to a low resistive state, and the first voltage converter outputs a high level. Meanwhile, the second switch is off, the resistive random-access memory M2 is set to a high resistive state, and the second voltage converter outputs a low level, that is, the D flip-flop outputs a low level. When the clock signal changes from the high level to a low level, that is, when CLK=0, the first switch is off, the resistive random-access memory M1 maintains the low resistive state, and the first voltage converter outputs a high level. Meanwhile, the second switch is on, an input signal of the second latch is at a high level, that is, V_{IN}=1, the resistive random-access memory M2 is set to a low resistive state, and the second voltage converter outputs a high level. That is, when the clock signal changes from a high level to a low level, the D flip-flop maintains the input signal at a time of the high level.

When the control signal is at a high level, that is, when CLK=1, the first switch is on; and if an input signal of the D flip-flop is at a low level, that is, V_{IN}=0, the resistive random-access memory M1 is set to a high resistive state, and the first voltage converter outputs a low level. Because the second switch is off when CLK=1, the resistive random-access memory M2 is set to a high resistive state, and the second voltage converter outputs a low level, that is, the D flip-flop outputs a low level. When the clock signal changes from the high level to a low level, that is, when CLK=0, the first switch changes from an on state to an off state, the resistive random-access memory M1 maintains the high resistive state, and the first voltage converter outputs a low level. Because the second switch is on when CLK=0, an input signal of the second latch is at a low level, that is, V_{IN}=0, the resistive random-access memory M2 maintains the high resistive state, and the second voltage converter outputs a low level. That is, when the clock signal changes from a high level to a low level, the D flip-flop maintains the input signal at a time of the high level.

As shown in FIG. 7, when a first falling edge arrives, V_{IN}=1, output of the D flip-flop changes from a low level to a high level, and the D flip-flop maintains the high level; when a second falling edge arrives, V_{IN}=1, and therefore, the D flip-flop continues maintaining the high level; when a third falling edge arrives, V_{IN}=0, and the D flip-flop changes from the high level to the low level, and maintains the low level; and when a fourth falling edge arrives, V_{IN}=0, and the D flip-flop continues maintaining the low level.

The D flip-flop in this embodiment includes cascading two latches constructed by using resistive random-access memories, and a latching function of the D flip-flop is implemented by means of a resistive state difference between the resistive random-access memories. Compared with the prior art, according to the solution in this embodiment, non-volatility is achieved, and because fewer components are used in the solution, a circuit structure is simple, a circuit area is reduced, the D flip-flop is compatible with an existing CMOS technology, and integrity of an existing logic circuit can be improved.

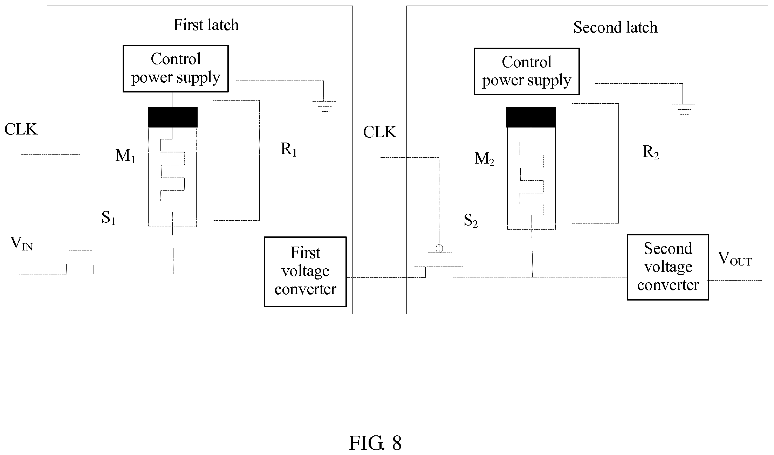

FIG. 8 is a schematic diagram of a circuit structure of another D flip-flop according to an embodiment of the present invention. A difference between this embodiment and the embodiment shown in FIG. 6 lies in that: in a first latch and a second latch in this embodiment, a switch is implemented by using one field-effect transistor, and a bleeder circuit is implemented by using a resistor. As shown in FIG. 8, the D flip-flop provided in this embodiment includes: a first latch and a second latch. The first latch includes: a field-effect transistor S1, a resistive random-access memory M1, a bleeder resistor R1, and a first voltage converter. The second latch includes: a field-effect transistor S2, a resistive random-access memory M2, a bleeder resistor R2, and a second voltage converter.

A gate of the field-effect transistor S1 is configured to input a control signal, and a drain of the field-effect transistor S1 is an input end of the D flip-flop. An output end of the first voltage converter is connected to a drain of the field-effect transistor S2. A gate of the field-effect transistor S2 is configured to input a control signal. The second voltage converter is an output end of the D flip-flop. In this embodiment, when the field-effect transistor S1 is a P-type field-effect transistor, the field-effect transistor S2 is an N-type field-effect transistor; or when the field-effect transistor S1 is an N-type field-effect transistor, the field-effect transistor S2 is a P-type field-effect transistor.

For a working principle of the D flip-flop provided in this embodiment, reference may be made to the description of the embodiment shown in FIG. 6, and details are not described herein again. Fewer components are used in the D flip-flop in this embodiment, so that compared with a D flip-flop in the prior art, the D flip-flop in this embodiment is simpler in structure and lower in cost.

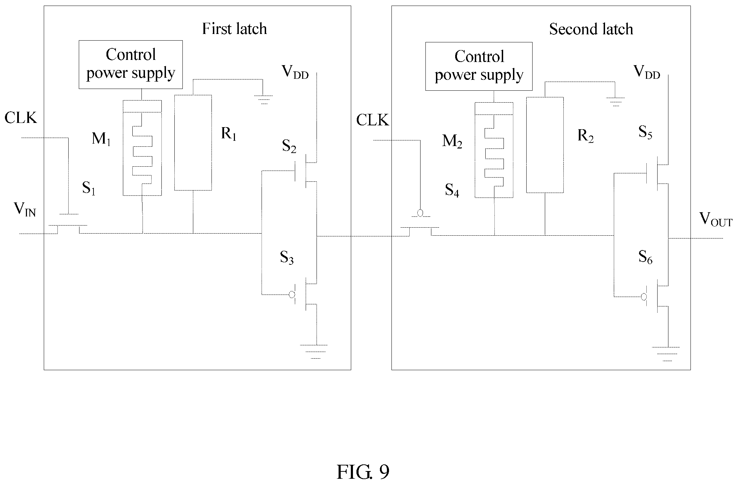

FIG. 9 is a schematic diagram of a circuit structure of still another D flip-flop according to an embodiment of the present invention. A difference between this embodiment and the embodiment shown in FIG. 8 lies in that: in this embodiment, a first voltage converter and a second voltage converter are each implemented by using two field-effect transistors. Referring to FIG. 9, the D flip-flop in this embodiment includes: a first latch and a second latch. The first latch includes: a field-effect transistor S1, a resistive random-access memory M1, a bleeder resistor R1, a field-effect transistor S2, and a field-effect transistor S3. The field-effect transistor S2 and the field-effect transistor S3 constitute the first voltage converter. The second latch includes: a field-effect transistor S4, a resistive random-access memory M2, a bleeder resistor R2, a field-effect transistor S4, and a field-effect transistor S5. The field-effect transistor S4 and the field-effect transistor S5 constitute the second voltage converter.

The field-effect transistor S1, the field-effect transistor S2, and the field-effect transistor S5 may be N-type field-effect transistors, and the field-effect transistor S3, the field-effect transistor S4, and the field-effect transistor S6 are P-type field-effect transistors. Alternatively, the field-effect transistor S1, the field-effect transistor S2, and the field-effect transistor S5 may be P-type field-effect transistors, and the field-effect transistor S3, the field-effect transistor S4, and the field-effect transistor S6 are N-type field-effect transistors.

For a working principle of the D flip-flop provided in this embodiment, reference may be made to the description of the embodiment shown in FIG. 6, and details are not described herein again. According to the D flip-flop in this embodiment, a nonvolatile latching function is implemented, and fewer components are used, so that compared with a D flip-flop in the prior art, the D flip-flop in this embodiment is simpler in structure and lower in cost.

It should be noted that the embodiments provided in the present application are merely exemplary. A person skilled in the art may clearly understand that, for the purpose of convenient and brief description, in the foregoing embodiments, the descriptions of the embodiments have their respective focuses. For a part that is not described in detail in an embodiment, reference may be made to related descriptions in other embodiments. Features disclosed in the embodiments of the present invention, the claims, or the accompanying drawings may exist independently or may exist in a combined manner, and features described in the embodiments of the present invention in the form of hardware may be executed by means of software, and vice versa, which is not limited herein.

## Claims

1. A latch, comprising a switch, a resistive random-access memory, a bleeder circuit, and a voltage converter, wherein:
a first end of the switch is configured to input a control signal, and the control signal is used to control the switch to be in an on state or an off state;
a second end of the switch is an input end of the latch;
a third end of the switch is connected to a positive electrode of the resistive random-access memory, a first end of the bleeder circuit, and an input end of the voltage converter;
a negative electrode of the resistive random-access memory is connected to a control power supply;
a second end of the bleeder circuit is grounded;
an output end of the voltage converter is an output end of the latch;
when the switch is in the on state, the voltage converter is configured to output an output signal of the latch according to an input signal of the latch, wherein the output signal of the latch remains consistent with the input signal of the latch; and
when the switch changes from the on state to the off state, the resistive random-access memory is configured to work together with the bleeder circuit to enable an output signal of the latch when the switch is in the off state to remain consistent with an output signal of the latch when the switch is in the on state.

2. The latch according to claim 1, wherein
when the switch is in the on state, the resistive random-access memory is configured to present a resistive state according to a difference between a voltage of the control power supply and a voltage of the input signal of the latch; and
when the switch changes from the on state to the off state, the resistive random-access memory is further configured to maintain the resistive state, to enable a voltage of the bleeder circuit to meet a preset condition, so that the output signal of the latch when the switch is in the off state remains consistent with the output signal of the latch when the switch is in the on state.

3. The latch according to claim 2, wherein:
when the resistive random-access memory maintains the resistive state, the voltage of the bleeder circuit is (R/(Rₘ+R))*Vₘ, wherein R is a resistance value of the bleeder circuit, Rₘ is a resistance value of the resistive random-access memory in the first resistive state, Vₘ is the voltage of the control power supply, and the first resistive state is a high resistive state or a low resistive state.

4. The latch according to claim 3, wherein:
the voltage converter is configured to: convert the voltage of the bleeder circuit to a high level if the voltage of the bleeder circuit is greater than or equal to a voltage conversion threshold; or convert the voltage of the bleeder circuit to a low level if the voltage of the bleeder circuit is less than the voltage conversion threshold; and
the voltage conversion threshold meets the following condition:
(R/(R+Rₘₕ))Vₘ≤Vₜₕ≤(R/(R+Rₘₗ))Vₘ,
wherein Vₜₕ is the voltage conversion threshold,
Rₘₗ is a resistance value of the resistive random-access memory in the low resistive state, and Rₘₕ is a resistance value of the resistive random-access memory in the high resistive state.

5. The latch according to any one of claims 1 to 4, wherein the switch comprises a field-effect transistor, a gate of the field-effect transistor is configured to input the control signal, a drain of the field-effect transistor is the input end of the latch, and a source of the field-effect transistor is connected to the positive electrode of the resistive random-access memory, the first end of the bleeder circuit, and the input end of the voltage converter.

6. The latch according to claim 5, wherein the field-effect transistor is a P-type field-effect transistor or an N-type field-effect transistor.

7. The latch according to any one of claims 1 to 6, wherein the bleeder circuit is a bleeder resistor.

8. A D flip-flop, comprising at least two latches according to any one of claims 1 to 7, wherein the at least two latches comprise a first latch and a second latch, wherein:
an output end of the first latch is used as an input end of the second latch;
a first end of a switch of the first latch and a first end of a switch of the second latch are configured to input a control signal, wherein the switch of the first latch and the switch of the second latch are not in an on state at the same time under the control of the control signal;
a second end of the switch of the first latch is an input end of the D flip-flop; and
an output end of a voltage converter of the second latch is an output end of the D flip-flop.

9. The D flip-flop according to claim 8, wherein when the switch of the first latch is a P-type field-effect transistor, the switch of the second latch is an N-type field-effect transistor; or
when the switch of the first latch is an N-type field-effect transistor, the switch of the second latch is a P-type field-effect transistor.
